# EUROPEAN PATENT SPECIFICATION

(11) **EP 1 902 470 B1**
(45) Date of publication and mention of the grant of the patent: **05.06.2013**
(21) Application number: 06725926.7
(22) Date of filing: 12.04.2006
(51) Int. Cl.: H01L 27/148, H01L 29/768, H04N 5/32, H04N 5/355, H04N 5/372

(54) **CCD SENSOR AND METHOD FOR EXPANDING DYNAMIC RANGE OF CCD SENSOR**
CCD-SENSOR UND VERFAHREN ZUM ERWEITERN DES DYNAMIKUMFANGS EINES CCD-SENSORS
CAPTEUR CCD ET METHODE POUR AUGMENTER LA PLAGE DYNAMIQUE D' UN CAPTEUR CCD

(30) Priority: 12.04.2005 FI 20050374
(43) Date of publication of application: 26.03.2008
(73) Proprietor: PLANMECA OY, 00880 Helsinki (FI)
(72) Inventor: DE GODZINSKY, Christian, FI-01260 Vantaa (FI)
(86) International application number: PCT/FI2006/050151
(87) International publication number: WO 2006/108927

(56) References cited:
- EP-A- 0 776 124
- JP-A- 9 074 181
- JP-A- 07 050 409
- JP-A- 08 298 626
- JP-A- 2002 135 657
- US-A- 5 432 335
- US-A- 5 867 215
- US-A- 6 028 299
- US-A1- 2002 126 213
- US-A1- 2005 001 914
- US-A1- 2005 012 968

## Description

### Field of the invention

The present invention relates to a CCD sensor arrangement according to the preamble of claim 1. In addition, the invention relates to a method for expanding the dynamics of a CCD sensor according to the preamble of claim 14.

### Background of the invention

A CCD device (Charge Coupled Device) can be defined as being a semiconductor device wherein, due to the movement of electric charges, storage and collection of charges is possible. These charge transfer devices are used in dynamic, variable storage elements, which characteristically have a high information density. In CCD sensors intended for X-ray imaging, the charges used for image generation, which are formed on physical pixels, can be combined, binned. Binning in a CCD sensor produces virtually larger image pixels. However, in certain situations, handling the charge of these combined pixels may be problematic. Especially at higher signal levels, the signal coming from the image area may be so large that, with the selected binning, the charges can not be combined within the CCD sensor without a risk of saturation of the output amplifier. This can be partially taken into account by designing the read-out register and the charge well of the output amplifier so that they have charge capacities higher than the charge capacity of the pixels. However, if the charge well of the output amplifier is enlarged too much, then the voltage generated on it is reduced, and thus the signal to be produced is also reduced.

At present, the resolution of digital imaging already approaches the level of film-based systems and may in some cases even exceed it. However, it is known that the dynamic range of CCD sensors, the ratio of the maximum signal to the open-circuit noise, to the basic sensitivity, is smaller than the dynamic range of traditional film-based systems. In this context, sensitivity may refer to resolution within background noise, in other words, to the signal size that can be resolved from background noise.

A typical non-cooled CCD device working in MPP mode has a dynamic range of about 10.000:1 ... 20.000:1. The figure giving the dynamic range represents the ratio of saturation voltage to RMS noise. If this dynamic range is effectively utilized, then it will be possible to exploit as many greyness levels as the A/D conversion used allows. For example, in the case of 14 bits, the total number of greyness levels available will be 16.384.

However, these numeric values are not mutually comparable when film-based and digital systems are compared to each other. Even if a film system would utilize only a small proportion of the total dynamics, in practice there would still be a very large number of greyness levels available. If one considers e.g. one thousandth (1:1000) of the dynamics of the film, it can be shown that this range is divided into more than 16 separate levels.

Moreover, CCD based sensors do not forgive in situations of overexposure as do film-based systems, in which the reciprocal law (gradual saturation, s-curve of the film) causes a soft saturation and along with this a "compression", i.e. an expansion of dynamics. It is thus conceivable that one is dealing here with an in-built non-linearity, which can also be understood as a kind of gamma correction in the film itself. In digital sensors, a visible boundary, artefact, is produced as soon as the maximum point of the dynamic range is reached.

The signal amplifier and A/D converter (A/D, Analog-to-Digital) connected after the sensor are designed with an aim to enable the entire dynamic range produced by the CCD sensor to be utilized. As mentioned above, existing CCD sensors can produce a dynamic range even exceeding 20000:1. In an ideal situation, the quantization step of the A/D converter is slightly below the CCD sensor's own noise level. However, this would mean that, in order to digitize the image, it would be necessary to use fast A/D conversion exceeding 14 bits.

In other words, the charge received and contained in a pixel may be so large that it can not be handled in a binning situation in the read-out register and/or in the charge well of the output amplifier without a risk of saturation. Especially in the case of larger binning operations, for example 3x3 and 4x4 (horizontal direction x vertical direction, the number of times of reading from the image area to the output register and from the output register to the read-out well), this becomes a problem. The image formed in the image area is not saturated and it is perfectly usable, but it can not be read out without saturation with the binning in question.

Both in cephalostatic use (Ceph) and in the panoramic image (Pan), there are areas below the jaws, which receive direct radiation without any intermediate tissue attenuating the radiation. In these situations, among others, there is an obvious risk of saturation if the system is otherwise tuned for optimal reception of the signal coming through the object. This makes imaging of e.g. soft tissue areas impossible, and in the areas of saturation all the image information is lost.

Document JP 07 050409 A discloses a CCD image sensor comprising a read out register which is connected with two read out wells having different capacities. The apparatus can operate in low and high sensitivity mode, which are selected based on brightness of the captured images. Depending on the selected capturing mode, which corresponds to the amount of collected charges, one of the read-out wells is used. As to when the operation mode may be changed, when called for, the document teaches changing it between sequential frames.

Document JP 08 298626 A discloses a CCD image sensor which comprises different read-out wells with different capacities, which are used based on whether a daytime or a nighttime imaging mode is selected. However, as in the case of abovementioned document, the apparatus disclosed in this document can not detect and correct luminance variation within a single frame, either.

### Brief description of the invention

Thus, the object of the invention is to develop a method and an apparatus implementing the method so as to allow the above problems to be solved. The object of the invention is accomplished by a method and system characterized by what is stated in the independent claims. Preferred embodiments of the invention are disclosed in the dependent claims.

The invention is based on using at least two output wells of different capacities and dynamically selecting during sensor read-out the read-out well to be used.

The method and system of the invention have the advantage of making it possible to expand the dynamic range of the CCD sensor and thus to prevent the sensor or a part of it from getting saturated.

### Brief description of the figures

In the following, the invention will be described in detail with reference to preferred embodiments and the attached drawings, wherein
Fig. 1 presents a device for increasing the dynamics according to a preferred embodiment;
Fig. 2 illustrates the structure of image data;
Fig. 3 presents by way of example a method for performing imaging and a logic for controlling the AGC function of an FPGA device during imaging;
Fig. 4 presents a table showing the typical charge handling capacities of the CCD sensor used;
Fig. 5 represents by way of example a charge capacity distribution in all units capable of electron charge transfer; and
Fig. 6 presents a four-chip CCD sensor and its control blocks.

### Detailed description of the invention

In the following, the invention and its preferred embodiments will be described by way of example with reference to a typical CCD sensor (manufactured e.g. by Atmel, Thomson) and charge capacity specifications optimized by also considering an automatic gain control function (AGC, Automatic Gain Control). The sensor may have e.g. the following properties:
1) Saturation charge of a separate single pixel (size: 33 µm x 33 µm): 600.000 electrons.
2) Saturation charge of read-out register:
   1.800.000 electrons.
3) Saturation charge of output amplifier A:
   2.400.000 electrons.
4) Saturation charge of output amplifier B:
   4.800.000 electrons.

When the sensor is operated in the horizontal direction (TDI direction, Time Delay Integration), with 3x3 binning the read-out register can hold a 100% signal of 3 successive pixels (3x600K=1800K, K=Kilo=1000). With 4x4 binning, four horizontal pixels charged to 75% of their capacity (1800K/4/600*100) can be summed without overflow. Overflow may mean that e.g. an electronic component, such as a capacitance, has no capacity left for additional charges. In overflow in the image area, an extra electron charge may move in the horizontal direction, and in overflow in the output register it may move in the vertical direction.

In the vertical direction (read-out direction), the situation is as follows. With 2x2 binning, 2 pixels having a 50% charge can be summed to one output A and 3 pixels with a 100% charge to a second output B without over flow. With 3x3 binning, 3 pixels having 44% of the charge can be summed to output A and 3 pixels having 88% of the charge to output B without overflow. With 4x4 binning, 4 pixels with a 25% charge can be summed to output A and 4 pixels with a 50% charge can be summed to output B without overflow.

From this it can be seen that even the less sensitive output B is unable to handle the signal coming from the image area without getting saturated if the signal exceeds 25% of the charge capacity of the physical pixel when output A is used. This situation can be corrected by applying the invention and its preferred embodiments.

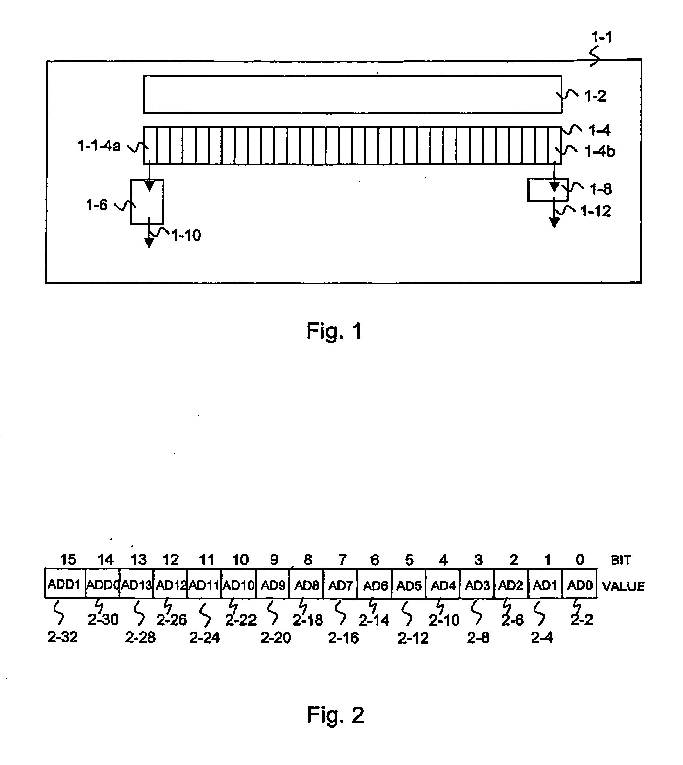

Fig. 1 presents a CCD sensor for expanding, increasing the sensitivity and thus dynamics according to a preferred embodiment. Here, reference number 1-1 represents an entire CCD sensor module, a detector. The active area of the detector, which comprises charge-receiving pixels, is indicated by a reference number 1-2. This image-forming surface in question may be a substantially even structure of any shape.

For example, the image information of a two-dimensional CCD sensor can be read out using a read-out register 1-4 placed on at least one edge, the register being functionally connected with said active area. Into this register it is possible to load e.g. one pixel column at a time. The pixels in the pixel column may be combined with each other, i.e. binned. The sensor also comprises means for transferring the charges to an output 1-4a, 1-4b of the read-out register 1-4. After the transfer, the register can be read e.g. serially by transferring the charge one pixel at a time, binned or without binning, into a charge well 1-6, 1-8 of the output amplifier, from where it can be further transferred out 1-10, 1-2 from the CCD sensor 1-1.

Thus, by using suitable arrangements, the charges can be transferred in the register in a desired direction, in the direction of a lower-capacity output well or in the direction of a higher-capacity output well. The choice of the output well to be used during imaging is optimized dynamically during imaging, so that the output well to be used and/or the size of the binning are/is selected e.g. by electronics, a suitable selection program or a combination of these.

An output well 1-6, 1-8 of the output amplifier may be located at either end of the register 1-4, or alternatively two or more wells and/or amplifiers may be placed at one end of the register or at least one well. may be placed at each end of the register. According to the invention and a preferred embodiment of it, the read-out register has at each end of it at least one charge well, read-out well 1-6, 1-8 and amplifier functionally connected with it.

An amplifier and/or buffer and/or buffer amplifier may be functionally connected with the well.

The dual amplifiers in question may be designed for different uses. For example, one of the amplifiers can be optimized for a so-called slow-scan mode, in which case the noise can be optimized to be as small as possible at the cost of speed. The other amplifier may be optimized for a so-called highspeed mode, in which case the reading rate can be optimized to be as fast as possible, but at the cost of noise.

However, in both traditional amplifiers, the output amplifier's charge wells have had the same capacity. According to the invention and its preferred embodiments, at least two output wells having different capacities are produced. The capacities preferably differ from each other substantially e.g. so that the larger output well has a capacity about twice that of the smaller output well. Other ratios can be used as well. If the number of wells is greater than two, then the capacities of at least two wells may differ from each other.

Thus, the invention and its preferred embodiments are based on the use of at least two charge wells of different capacities and on the possibility of dynamically selecting during read-out the output well to be used. This selection can be made depending on the signal, on the basis of signal data, e.g. image signal.

As compared to a situation where only one output amplifier is used or, on the other hand, where two output amplifiers having the same capacities are used, this arrangement provides the advantage of allowing saturation of the internal shift wells and read-out wells (not of the image area) of the CCD sensor to be avoided. In addition, by applying the invention and its preferred embodiments, the A/D converter can be prevented from being saturated. Both situations are very likely to occur when the charges of pixels are being combined, i.e. binned, with pixels larger than 2x2.

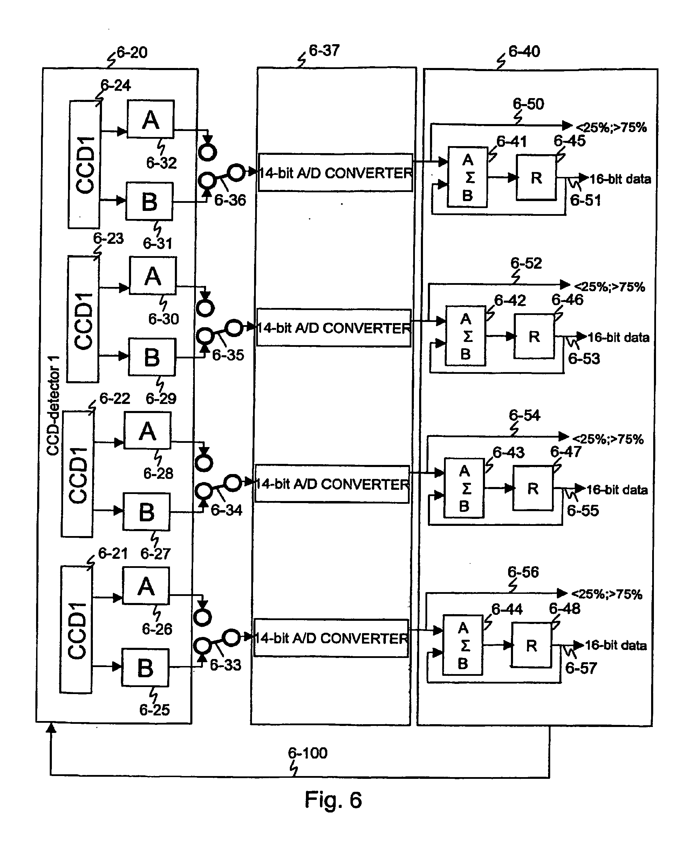

Fig. 2 illustrates the structure of an image data set. In the figure, the lowest 14 data bits (ADO-AD13: Fig. 6: 6-51, 6-53, 6-55, 6-57) may come from the 16-bit summer (Fig. 6: 6-41, 6-42, 6-43, 6-44) of the image data processing module of the FPGA device (Fig. 6: 6-40) (FPGA, Field Programmable Gate Array) and from the register (6-45, 6-46, 6-47, 6-48) which can store the intermediate sums. This summer can be reset before the sampling of each pixel, and the 14-bit result obtained from the A/D converter can be added once to this summer. It is also possible to add the value +1 to the sum to ensure that the result is always greater than 0. This result is a 14-bit number and the highest 2 bits (ADD0 and ADD1) are zeros.

In a certain case, the values of four successive A/D converters are added to this summer, whereby the result approaches the 16-bit maximum. If one additionally considers the fact that each chip of the CCD sensor may have two outputs (Output A and Output B, one of which may give a double signal with the same radiation), one is able to note that the overall dynamics of the system is 17 bits, i.e. 131 072 greyness levels (16384 x 4 x 2).

One CCD sensor (Fig. 6: 6-20) may consist of one or more, e.g. four chips (Fig. 6: 6-21, 6-22, 6-23, 6-24) seamlessly connected one after the other. A separate clock signal can be applied to each chip. In Ceph operation, two identical CCD sensors are used. Each chip has two outputs (Fig. 6: 6-25 ... 6-32). One of these may be a more sensitive so-called high-sensitivity output, i.e. A output, and the other one may be a less sensitive so-called high-capacity output, i.e. B output. Thus, one CCD sensor may have a total of 8 digitizing outputs, of which e.g. only four outputs are used simultaneously. In practice, the ratio of the capacities of the A and B outputs is very precisely ½, i.e. the signal of the B output is equal to half the signal of the A output with the same amount of radiation.

If more than one chip is used, each one of the different chips can handle data obtained from a given part of the patient and/or function in a different mode, and each chip can be controlled individually or separately.

The output in use can be selected (switches 6-33 ... 6-36 in Fig. 6) e.g. manually via a control register. Alternatively, the AGC function or a test function may decide about the output. All 8 outputs can be digitized by A/D converters, the number of which may be e.g. three. Each A/D converter may contain a 3-input multiplexer, i.e. selector, so the total number of channels to be digitized in this case is 9. An extra tenth channel is in test use, which can be applied to measure the noise of the electronics and the A/D conversion.

Fig. 6 presents a situation where the selecting element 6-33 ... 6-36 after the output wells 6-25 ... 6-32 routes one of the wells to one A/D converter 6-37. Alternatively, it is possible to perform an A/D conversion on the outputs of both wells and only then to have the selection element make a choice as to the one of the wells whose digitized signal is to be used. The selection element may also form part of the A/D converter and it may be e.g. an analog or digital switch. Fig. 6 also illustrates a possible solution 6-100 for bringing clock signals and/or control signals from the FPGA element 6-40 to the CCD sensor 6-20.

AGC function refers to automatic control of level or gain. However, it does not refer to the gain of the programmably variable PGA amplifiers (Programmable Gate Array) within the A/D converters, the gain of which amplifiers can be adjusted e.g. in the range 1 ... 6. This gain can be adjusted separately for each CCD chip, and the adjustment is used primarily for the optimization of basic sensitivity in accordance with the imaging conditions (Pan/Ceph).

The AGC method can be utilized in a camera e.g. in the following two ways. Either one of the output amplifiers A or B of each CCD sensor can be used as far as applicable. Since the B amplifier has a signal handling capacity about twice that of the A amplifier, virtually one additional bit is obtained in the A/D conversion. Alternatively, it is also possible to use binning performed outside the CCD sensor. However, this is only possible when binning done in the direction of the read-out register.

If in cases of high binning, e.g. 4x4 binning, the B output amplifier is getting saturated, then it is possible to shift to a lower binning within the CCD sensor, e.g. to 4x2 binning. The pixel values can now be sampled twice by the A/D converter, and the summing can be performed e.g. within the FPGA device in an arithmetic unit. Multiple summing of the offsets caused by the electronics can be compensated for by computer software. This external summing may even be in the form of 4x1 binning and 4 summing operations.

To reduce the binning, instead of summing e.g. four charges, it is possible to combine only 2 pixels in the charge well, digitize the pixels, take the next two pixels, digitize the pixels and only then sum the digitized results digitally.

In the above-described manner, the overall dynamics can be increased to 17 bits, of which 14 bits are obtained from the A/D conversion, 1 bit from the output of the A or B amplifier and 2 bits from the external summing, which, as stated above, can be performed 4 times.

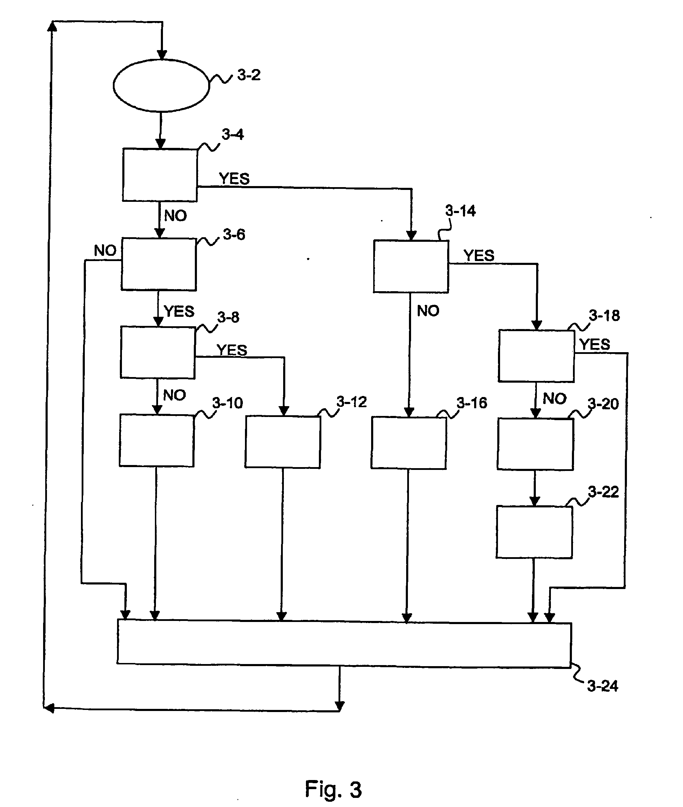

Fig. 3 illustrates by way of example a method for performing imaging and presents the control logic controlling the automatic gain control (AGC) of the FPGA device during imaging. Imaging is normally started with a selected initial value, default binning. At the beginning, output A of each CCD sensor chip can be used. As the read-out register of each chip can be controlled individually, it is possible to choose on a chip-specific basis the direction in which the charge is to be shifted. As stated, the charge can be shifted either in the direction of output A (1-8: Fig. 1) or in the direction of output B (1-6: Fig. 1).

The logic of the FPGA device can continuously monitor the A/D conversion signal of each chip separately. At stage 3-2, a new vertical column is read from the CCD sensor into memory. At stage 3-4, a check can be carried out to see whether even one of the currently used A/D-converted CCD-sensor outputs (Fig. 6: 6-50, 6-52, 6-54, 6-56) produced a signal exceeding e.g. 75% from the A/D converter. (information regarding the signal size can be transferred to an inference block and e.g. to a status machine (Fig. 6: 6-50, 6-52, 6-54, 6-56). Thus, if the signal or a part of it exceeds a predefined value, e.g. ¾ of the range of the A/D converter, then it is possible to shift to using the less sensitive output, output B, in those chips that meet this condition. If all the outputs are below the first threshold value, then a check can be made at stage 3-6 to determine whether all the currently used CCD-sensor outputs produced a signal below a second predefined threshold value, e.g. 25%, from the A/D converter. If all the outputs are below the second threshold value, then a check can be made at stage 3-8 to establish whether the smallest register-direction binning outside the CCD sensor has already been reached. If the smallest external binning has not yet been reached, then the procedure can move on to stage 3-10, where, on the next vertical column, it is possible to shift to an external binning size reduced by one step. On the other hand, if the smallest external binning has already been reached, then at stage 3-12, on the next vertical column, for those B-outputs of the CCD sensor which remain below the value, it is possible to shift to using output A. In other words, if the signal correspondingly remains e.g. entirely below a certain predefined second value, e.g. ¼ of the range of the A/D converter, then it is possible to shift to using the more sensitive output, output A, in those chips that meet this condition.

If at stage 3-4 at least one output exceeds 75% of the signal from the A/D converter, then the procedure can go on to stage 3-14. Here a check can be made to see whether any one of the outputs having produced a signal exceeding 75% is a B output. If not, then for the exceeding A outputs of the sensor it is possible to shift to using the B output on the next vertical column at stage 3-16.

If the signal still exceeds ¾ of the range of the A/D converter in any one of the A/D converters of the CCD sensor chips although a shift to using output B has been made, i.e. where the B output is digitized, then at stage 3-18 a check can be made to determine whether the maximum register-direction external binning has already been reached. If the register-direction external maximum binning has not yet been reached, then at stage 3-20 on the next vertical column it is possible to shift to using a register direction arithmetic external binning size increased by one step e.g. for all chips. If necessary, the binning can be changed gradually from 4x4 level to 1x4 level and back to 4x4 level. This reduction of binning is not externally visible in the image data because, in addition to the binning done inside the sensor, binning is also performed after the A/D conversion, in other words, several A/D conversions per pixel can be performed. The result is still the same, because this is taken into account in the compensation of dark current. Dark current may refer to the leakage current caused by non-idealities of silicon, as a result of which electrons leak into pixels, producing a base signal. The signal may be doubled as the temperature always rises about +7°C. The dark current is not uniform but may have a different effect on different pixels.

The structure and timing of the FPGA device can be optimized even in regard of this property. At stage 3-22, the use of the A output can be resumed for all CCD sensors whose B output has a level below the second threshold value, e.g. below 25%. If external maximum binning in the register-direction has already been reached, then the procedure can move on from stage 3-18 to stage 3-24. Likewise, after stages 3-10, 3-12, 3-16 and 3-22 the procedure can move on to stage 3-24, to await the digitization of the next vertical column.

Thus, if the AGC function has been activated, in the gain control automatics the camera head can independently make its conclusions regarding binning and the A/B outputs to be used, in accordance with predefined conditions. The logic of the FPGA device can be so constructed that it comprises a hysteresis to prevent jumping from one output to another. The image data being produced can be marked by the camera head to allow the computer software to carry out corresponding actions required in the processing of image data regardless of e.g. how the virtual pixels have been produced.

According to the invention and its preferred embodiments, when at least two different output wells having different capacities are used, the status diagram in Fig. 3 can be presented in the following form. When the lower-capacity output well is being used, a check is made to determine whether the signal or a part of it exceeds the first predefined value, e.g. value 75%. If this is the case, then a shift to using the output well of higher capacity is made. Again, when the higher-capacity output well is being used, a check is made to see whether the signal or a part of it remains below the second predefined value, e.g. value 25%. If this is the case, then a shift to using the lower-capacity output well is made.

It is also possible to extend the status diagram so that it comprises more than two output wells. It is then possible to shift from using a smaller output well to using a larger output well and further the next output well, e.g. a still larger output well. Correspondingly, it is possible to shift from using a larger output well to using a smaller output well and further the next output well, e.g. a still smaller output well.

As described above, in the start-up it is possible to set out in a predetermined manner with all chips of the CCD sensor. The starting situation may be fixed and always the same: output A for all CCD sensors, normal selected CCD sensor pixel binning, no external binning outside the CCD sensor. Thus, imaging can always be started from maximum sensitivity with the selected pixel size. External binning outside the CCD sensor to be implemented by summing can also be defined separately, if it is not desired that the AGC function automatically shifts to the lowest possible sensitivity. It is also to be taken into account that after the ENABLE signal has been activated e.g. internally, the FPGA device executes a calibration sequence in which both the A direction and the B direction can be read alternately forwards or backwards. During this calibration, the AGC function can be automatically disabled, and, when selected, it can only be activated after the calibration sequence.

As described above, when automatically moving in the less sensitive direction, on the next column it is possible, if allowed, to shift to using the B output of the CCD sensor chip. This can be used if, when the A output is being used, there are e.g. n A/D conversions exceeding the 75% level. This consideration can be implemented individually for all chips of four or eight pieces. The number n can be selected within the range of 1 ... 16. The default can be assumed to be 1. The actual number to be used depends on how many defective rows producing too large a signal there are at the most in one and the same chip.

If it is possible or allowed, on the next column the procedure can shift to using a smaller register-direction binning internally within the entire sensor if, of the A/D conversions of the B output of any one of the chips of the CCD sensor 1 ... 16 pcs, still exceed 75%. At the same time, possible chip-specific shifts from output B to output A can be implemented, this allowing possible increases in sensitivity. In the shift from output A to output B, decreases in sensitivity can be disabled. In this situation, simultaneous AB sensitivity decreases can be prevented if at the same time a shift to external binning is made. Otherwise, the signal of these outputs may fall to one fourth instead of one half.

When a shift is made automatically in the more sensitive direction, on the next column it is possible to shift to using a larger register-direction internal binning within the CCD sensor, unless the largest possible binning is already being used, if a maximum of m pcs of the A/D conversions of the outputs of the chips using the B output exceed 25%. The number m can be selected in the range of 1 ... 16 and the default value can be considered as being the value 1. The actual number to be used may depend on e.g. how many defective, saturated rows producing too large a signal there are at most in one and the same CCD chip.

In this case, in chip-specific shifts from output B to output A that may take place, increase in sensitivity can be disabled, and in shifts from output A to output B decrease in sensitivity can be enabled. In this situation, simultaneous AB sensitivity decreases can be disabled automatically if at the same time a shift is made to smaller external binning. Otherwise the signal of these outputs would be quadrupled instead of doubled.

If the A/D conversion of the output of any chip does not exceed 25% when the B output is being digitized, then on the next column a shift to using the A output of the chip can be made.

A corresponding procedure can be followed when the Ceph method is being used in a CCD sensor head containing two CCD sensor packages. The FPGA device of the CCD sensor (DIMAX2) is able to separately control the read-out direction of the register of a total of eight discrete chips and to collectively control the vertical binning of all the chips.

Arranging for the vertical binning to be differently sized for different chips of the CCD sensor is also possible, although it involves more complexity in both the hardware and software required.

When the gain is altered in the above-described manner, the system noise and X-ray quantum noise present in the signal may also be different in magnitude on different outputs (output A / output B) and/or with A/D binning. The noise may be reduced when binning is done using an A/D converter. If necessary, this can be taken into account in the software, where noise can be summed artificially onto those areas where it is smaller due to the binning method.

In some pixels, dark current can be reduced several times, depending on the binning method. This can be accomplished e.g. mathematically and via software. If necessary, dark current calibration and gain calibration can be performed for both the A output and the B output. The FPGA device allows measurement of the signals of both outputs.

However, it is to be noted that in the case of small binning sizes (2x2 or 1x1), the automatic gain control function is not of use.

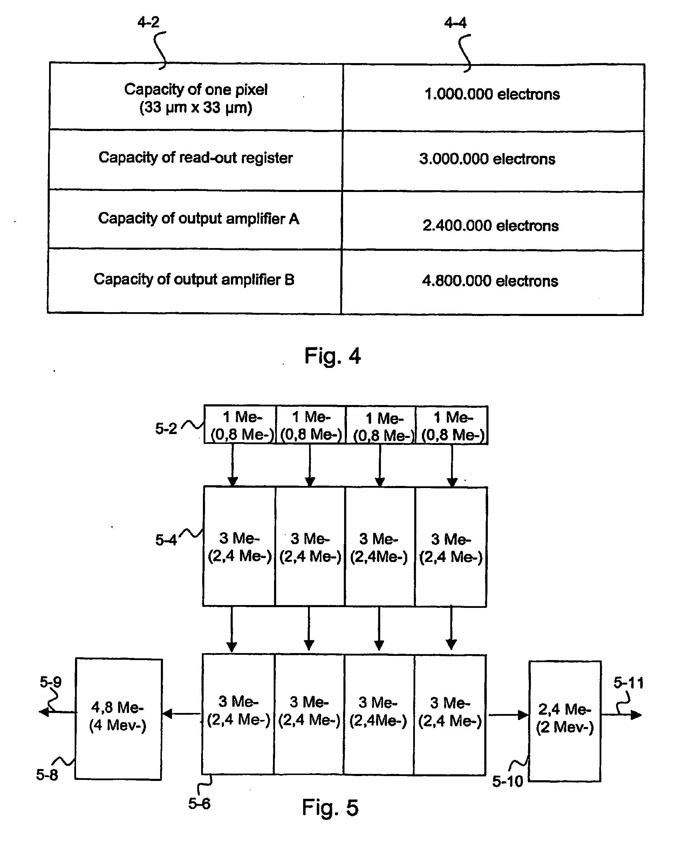

Fig. 4 presents a table showing typical charge handling capacities of a CCD sensor used. In the figure, column 4-2 represents the capacity and column 4-4 represents the number of electrons. It can be seen from the table that, when the capacity of one pixel (33µm x 33µm) is 1 million electrons, the capacity of the read-out register is 3 million electrons, the capacity of output amplifier A is 2.4 million electrons and the capacity of output amplifier B 4.8 million electrons. The guaranteed minimum capacities are at a level about 20% lower.

Fig. 5 presents by way of example a charge capacity distribution in units capable of electron charge transfer. Block 5-2 represents four pixels in the image area with a typical saturation, which is about 1 million charges, at a minimum 800000 charges. The saturation value of each pixel is about 0.8 ... 1Me.

Each pixel in the image area can be combined with a pixel in the summing register. Block 5-4 represents four summing register pixels with a typical saturation value, about 3 million charges, and the value at its minimum, about 2.4 million charges. Thus, the saturation value of each pixel is about 2.4 ... 3 million charges.

Each pixel in the summing register can in turn be combined with a read-out register. Block 5-6 represents the typical saturation and minimum values of four read-out registers, 3 million charges and 2.4 million charges, respectively. Block 5-8 represents a typical saturation value of output well B, about 4.8 million charges, and minimum value, about 4 million charges, respectively. The output signal 5-9 of output well B is typically about 3 volts, at a minimum about 2 volts. Block 2-10 again represents a typical saturation value of output well A, about 2.4 million charges, the minimum value of this amount of charge being 2 million charges. The output signal 2-11 of output well A is typically about 3 volts, at a minimum about 2 volts. In Fig. 2, the basic sensitivity is about 60 mV / mR with 3x3 binning. The pixel size is about 99 micrometers.

From the example in Fig. 5, it is possible to derive the situation in the horizontal direction. In this case, with 4x4 binning it is possible to bin 4 horizontal pixels from the image area, the image areas having a 75% degree of fullness (3000000/4=750000), without overflow occurring in the read-out register. With 3x3 and smaller binning sizes, pixels in the image area can be binned freely into the read-out register without overflow occurring in it.

However, it is to be noted that the output wells have to be designed to be sufficiently small to avoid a loss of sensitivity of the CCD device. The output voltage 5-9, 5-11 is then suitable for the A/D conversion, so that it is sufficient in respect of both signal-to-noise ratio and resolution. This may involve limitations, even when output wells of different capacities are used.

In the vertical direction, the read-out direction, the total signal level in the case of 4x4 binning is about 4 x 4 x 1 Me = 16 Me (million electrons). This is about 6.6 times more than the capacity of output well A, and about 3.3 times more than the capacity of output well B. Thus, with this binning, the largest average charge to be handled, for the whole capacity of e.g. a 33-µm pixel before saturation of the output well, is about 15% of the value obtained when the A output is used and about 30% of the value obtained when the B output is used.

When 3x3 binning is used, the total signal level is about 3 x 3 x 1 Me = 9 Me. This is about 3.75 times more than the capacity of output well A and about 1.875 times more than the capacity of output well B. Thus, with 3 x 3 binning, the largest average charge to be handled, for the whole capacity of e.g. a 33-µm pixel before saturation of the output well, is about 26.6% when the A output is used and about 13.3% when the B output is used.

When 2 x 2 binning is used, the total signal level is about 2 x 2 x 1 Me = 4 Me. This is about 1.66 more than the capacity of output well A. However, output well B is large enough to hold this entire 4-Me capacity. Therefore, with this binning the largest average charge to be handled, for the whole capacity of e.g. a 33-µm pixel before saturation of the output well, is about 60% when the A output is used, but about 100% when the B output is used.

If no binning is done, the total signal level is about 1Me, i.e. the same as the level of the pixel. In this case, both the internal registers and the output wells can handle the signal without a risk of saturation.

From Fig. 5 it can be seen that the less sensitive B output is unable to handle the signal coming from the image area with 4x4 binning without being saturated if the signal exceeds about 30% of the charge storing capacity of the physical pixel. However, this problem can be solved by applying the invention and its preferred embodiments.

The aim of the invention and its preferred embodiments is thus to expand the dynamic range of the CCD sensor by external means to be as wide as possible. According to the invention and its preferred embodiments, the amplifiers can be optimized in respect of noise and speed e.g. for real-time TDI read-out of an X-ray image when the capacities of the charge wells are different. This procedure allows the dynamic range handled by the CCD sensor to be e.g. doubled or quadrupled when larger binning sizes, e.g. over 2x2 binning, are used.

In addition, in the arrangement the signals of both output amplifiers can be digitized either simultaneously or alternately. The choice of which one of the two output amplifier signals is to be used depends on the signal itself. With a suitable arrangement, it is possible in a CCD sensor, which may consist of a plurality of CCD sensor chips, to handle the signal of each CCD sensor chip separately and likewise to decide separately which one of the amplifiers is to be used in each chip. This decision can be made column for column, and thus the signal level can be monitored dynamically and maximized over the entire image area. The automatic selection of register read-out direction and therefore selection of the amplifier can be made e.g. independently, by means of the controlling FPGA device. The information as to which amplifier has been used can be transmitted in the image data separately line by line and also separately for each CCD so that the calibration program will be able to take this into account in the processing of image data. Image data can be shifted at 16 bits/pixel even in the case of a 14-bit conversion.

If e.g. a 14-bit A/D conversion is used, it can easily be increased virtually to a 15-bit conversion (doubling of dynamics, if the capacity ratio of the wells of the output amplifiers is 2:1) still using the same A/D conversion.

In a CCD sensor camera it is thus possible to select whether output A or output B is to be used. This selection can be made e.g. manually or automatically using an AGC device separately for each chip, e.g. for all eight chips. Yet both register-direction binning and horizontal binning are always the same for all chips. If this procedure were not followed, the image data produced to the computer would contain pixels of different sizes. Even if the camera head of the camera shifts to using a smaller binning size internally in the CCD sensor, the virtual pixels remain the same size. A missing binning within the sensor can be replaced invisibly by A/D binning.

In other words, the binning is common to all the chips, whereas the A/B direction can be selected individually either manually or automatically with the help of the AGC device separately for each chip. It is also possible to differentiate the AD binning on a chip-specific basis.

In a preferred embodiment, some of the chips may shift back to using the more sensitive A output, whereas the other chips may produce a signal so large that both the B output and external binning outside the CCD device are required. In other words, if the B output of any one of the chips produces too large a signal so that a shift has to be made to using a smaller internal binning, the other chips can freely move back in the A-direction if the signal in them falls too low. The control logic for the A/B outputs, i.e. for a total of e.g. 8 chips, may be separate, but the FPGA device may have a common binning logic within it.

According to the invention and its preferred embodiments, the dynamics of the A/D converter of the CCD sensor (the DIMAX2 device has a 14-bit A/D converter = 16384 discrete levels) can be expanded e.g. to be eight times higher (17 bits = 131072 discrete levels). This expansion takes place in the CCD sensor head (DIMAX2) automatically and depending on the image signal. The dynamics can be doubled when a shift is made to using the output well of larger capacity instead of the smaller output well. The dynamics can be further increased fourfold when a shift is made to using 4x2 binning instead of 4x4 binning and after this to using 4x1 binning. In all, by this way the dynamics can thus be increased by the aforementioned amount, in other words, the dynamics can be octupled.

The sensor is able to send the image data in a genuine 17-bit format to the computer. Moreover, it is to be noted that the image data can be compressed on the computer to a 12-bit format (in future to a 16-bit format) as soon as the minimum and maximum intensities are known. Regardless of this, it is preferable to image the object itself using maximum dynamics. Gamma correction can be performed simultaneously while the image data is being converted to 12-bit format, so that maximal dynamics can be preserved in the final image.

Pixel binning can also be performed alternately using binning where two pixels are binned in the register direction of the CCD sensor and sampled and after this one further pixel is digitized without binning and this result is added to the previous binned pixel. This binning method can be used if the selected original binning in the register direction is about three-fold and if it is necessary to move in the less sensitive direction while the AGC device is in an activated state.

During this 3x binning there may occur errors of symmetry when a shift is made to external summing binning, if 2 pixels binned within the CCD sensor are summed first and then additionally one separate CCD device. However, even this situation can be taken into account by software.

The AGC function is only dependent on register-direction binning. Binning in the horizontal direction, in the TDI direction, is of no consequence. Horizontal binning may be different than vertical binning. In this case, however, the pixels produced are not the size of an equilateral square.

The invention and its preferred embodiments also provide means for ensuring that that the CCD sensor has separate outputs for at least two capacities.

An arrangement according to the invention and its preferred embodiments can be integrated on a single CCD chip using one or more microcircuits. It is also possible to additionally integrate e.g. PGA amplifiers in the CCD pre-stages of the device. The gain of these amplifiers is adjustable e.g. in the range of x1 ... x6 in 64 steps (at present x1).

By applying the invention and its preferred embodiments and adjusting the gain to a suitable value relative to the signal level (Ceph/Pan), an optimal result can be achieved in respect of both noise and dynamics. Since the signal level particularly in Ceph images is very low, extra gain can be utilized to reduce subsequent image processing artefacts and system noise. Moreover, the device according to the invention and its preferred embodiments still prevents saturation. Also, for instance, it is possible in the same skull imaging to have the soft tissue areas included in the image e.g. via software (soft-tissue filter).

A CCD sensor according to the invention and its preferred embodiments produces 16-bit image data, pixels, with very high dynamics, the structure of such image data being illustrated by way of example in Fig. 2. As shown, 2 bytes are needed to represent the grayness level of a pixel. The first byte occurring in the data flow contains the lower 8 bits (AD0-AD7) while the byte coming next contains the upper 8 bits (AD8-ADD1). The A/D conversion in itself is a 14-bit conversion. This bit count of the A/D conversion is justifiable by the fact that the system's own noise is very low.

Thus, the CCD sensor according to the invention and its preferred embodiments solves the problems of limited dynamic range and slow recovery from an saturated situation. By using a 14-bit conversion and keeping the system noise at a low level, an ideal situation is achieved where one step of the A/D converter corresponds to the noise level of the output amplifier of the CCD sensor. The signal-to-noise ratio of the final image is determined by the quantum noise of the X-ray beam. In a normal imaging situation, the two topmost bits (ADD1 and ADD0) of the 16-bit pixel value may be zeros.

However, exceptions occur in two situations. The function of the automatic gain control according to the invention and its preferred embodiments may, in the case of a large amount of radiation, have transferred binning of the CCD sensor pixels into a form in which register-direction binning is done by binning fewer pixels together. For the situation to remain the same, sampled values of successive pixels can be summed within the FPGA device. Thus, x4 binning may be changed e.g. to the form x2 + x2 or, in the worst case, to the form x1 + x1 + x1 + x1. In this situation, the value of the 16-bit pixel approaches the value 0xFFD when four 14-bit values are summed together. However, the AGC device can take care of all this independently. In this summing situation, an amount of dark current offset corresponding to the number of summing operations can be subtracted from the signal.

It is obvious to a person skilled in the art that, with the development of technology, the basic concept of the invention can be implemented in many different ways. Thus, the invention and its preferred embodiments are not limited to the examples described above but may vary within the scope of the claims.

## Claims

1. CCD image sensor arrangement (1-1), comprising a CCD sensor, which comprises
- a detector (1-2) which includes an active area comprising pixels that receive charges;
- a read-out register (1-4) which is functionally associated with the aforesaid active area;
- means for transferring charges from the active area into the read-out register (1-4);
- means for transferring charges to an output (1-4a, 1-4b) of the read-out register (1-4);
- at least two, a first and a second read-out well (1-6, 1-8) functionally connected with the read-out register (1-4), said at least two read-out wells (1-6, 1-8) having different capacities; and
- means for transferring charges from the output (1-4a, 1-4b) of the read-out register (1-4) into a read-out well (1-6, 1-8),
**characterized in that** means are arranged in the sensor or in functional connection with the sensor for measuring the signal generated by the charges during read-out of an image from the sensor, as well as selection means for deciding during said read-out of said Image from the sensor on the basis of the aforesaid measured signal whether the read-out well (1-6, 1-8) into which charges are to be transferred from said read-out register (1-4) Is to be changed.

2. Sensor arrangement according claim 1, **characterized in that** it comprises a means to perform an A/D conversion to said signal and said selection means is adapted to select, after the A/D conversion, the read-out well (1-6, 1-8) through which the signal coming from the CCD sensor (1-1) is to be read.

3. Sensor arrangement according to claim 1 or 2, **characterized in that** means are arranged in the sensor or in functional connection with the sensor, which are adapted to check (3-4) whether at least part of the measured signal exceeds or is below a predefined first threshold value; and if it does, to give a signal that the read-out well (1-6, 1-8) to be used is to be changed to one of different capacity.

4. Sensor arrangement according to any one of the preceding claims, **characterized in that** the sensor comprises two read-out wells (1-6, 1-8) which are located at opposite ends of the read-out register (1-4) or at one end of the read-out register.

5. Sensor arrangement according to any one of the preceding claims, **characterized in that** the sensor comprises a first and a second read-out well (1-6, 1-8) and the capacity of the second read-out well (1-6) Is equal to about twice the capacity of the first read-out well (1-8).

6. Sensor arrangement according to any one of the preceding claims, **characterized in that** it comprises a register arranged between the detector (1-2) and the read-out register (1-4), in functional connection with these, for summing the charges before transfer of them into the read-out register (1-4).

7. Sensor arrangement according to any one of the preceding claims, **characterized in that** it comprises a register where the charges of the pixels of the active area may be transferred to before transfer of them into the read-out register (1-4).

8. Sensor arrangement according to any one of the preceding claims, **characterized in that** the arrangement comprises means for changing the dynamics by changing binning of charges at least partly in response to a control signal.

9. Sensor arrangement according to any one of the preceding claims, **characterized in that** the arrangement comprises means for changing the dynamics by changing binning of charges at least partly according to a control signal during transfer of charges from the output (1-4a, 1-4b) of the read-out register (1-4) into the at least one read-out well (11-6, 1-8) at least partly In response to a control signal, whereby means is arranged in the sensor or in a functional connection with the sensor for measuring the signal generated by the charges read out from the read-out well as well as selection means for deciding, at least partly on the basis of the measured signal, whether the binning (1-6, 1-8) Is to be changed.

10. Sensor arrangement according to claim 8 or 9, **characterized in that** it comprises means to change the binning upon transfer of charges from said active area of the detector to the read-out register and/or upon transfer of charges from the read-out register to the read-out well.

11. Sensor arrangement according to any one of the preceding claims 8-10, **characterized in that** the control signal is based on a signal read out from the CCD sensor.

12. Sensor arrangement according to any one of the preceding claims 8-11, **characterized in that** the arrangement comprises means for normalizing the image signal, which normalizing means comprise digital summing of the signals produced by pixels located physically adjacently to each other on the sensor.

13. Sensor arrangement according to claim 12, **characterized in that** the normalizing means comprise means for correction of the dark current and/or the gain and/or the electronics offset being dependent on the binning.

14. Sensor arrangement according to claim 12 or 13, **characterized in that** the summing and/or the correction are/is implemented partly electronically and partly by software.

15. Sensor arrangement according to any one of the preceding claims, **characterized in that** it comprises means adapted to determine the binning to be used and/or the output well to be used on the basis of at least one clock pulse and/or means for changing the clock pulse at least partly on the basis of the signal coming from the CCD sensor.

16. Sensor arrangement according to any one of the preceding claims 2-15, **characterized in that** it comprises means adapted to check (3-4) whether the A/D conversion exceeds a predefined first threshold value; and if the A/D conversion exceeds the predefined first threshold value, to additionally check (3-14) whether the read-out well (1-6, 1-8) of larger capacity is being used, and if it is not being used, to make a shift (3-6) to using In the reading of the next vertical line of the detector the read-out well (1-6, 1-8) of larger capacity instead of the read-out well (1-6, 1-8) of smaller capacity.

17. Method for expanding the dynamics of a CCD sensor (1-1), **characterized in that** at least two, a first and a second read-out well (1-6, 1-8) having different capacities are arranged In functional connection with a read-out register (1-4) of the CCD sensor (1-1), which method comprises the steps of
- receiving charges in an active area comprising pixels in at least one vertical line
- reading (3-2) the charges of the first vertical line of pixels from the active area into the read-out register (1-4);
- transferring the charges to an output (1-4a, 1-4b) of the read-out register (1-4);
- transferring the charges from the output (1-4a, 1-4b) of the read-out register (1-4) into a read-out well (1-6, 1-8),
- measuring the signal generated by the charges coming out from the sensor via said read-out well (1-6, 1-8) and
- deciding during read-out of an image from the sensor and on the basis of the measured signal whether the read-out well (1-6, 1-8) to be used is to be changed.

18. Method according to claim 17, **characterized in that** an A/D conversion is performed on the signal of at least one read-out well and after A/D conversion, the read-out well (1-6, 1-8) through which the signal coming from the CCD sensor (1-1) is to be read is selected.

19. Method according to claim 17 or 18, **characterized in that** a pixel line or a number of pixels are read out and a check (3-4) is made based on a signal of at least a part of said pixels read out whether the signal exceeds or is below a predefined threshold value; and if is, a shift (3-16) is made to using in the reading of the next vertical line of pixels a read-out well (1-6, 1-8) of different capacity.

20. Method according to claim 19, **characterized in that** predefined threshold values 75% and 25% are used.

21. Method according to any one of the preceding claims 17-20, **characterized In that** the signal level of the signal read out from the sensor is measured, and if the signal level exceeds a predefined threshold value, then the read-out of charges from the sensor is adjusted in such manner that, before the charges in the read-out well are read out, the number of pixels to be transferred into the read-out well is decreased, and if the signal level Is below the predefined threshold value, then the read-out of information is adjusted in such manner that, before the charges in the read-out well are read out, the number of pixels to be transferred into the read-out well is increased.

22. Method according to claim 21, **characterized in that** a decision whether the read-out well (1-6, 1-8) to be used is to be changed is made based on a predefined threshold value which is determined as a function of saturation level of the read-out well.

23. Method according to any one of the preceding claims 17-22, **characterized in that** the signal level of the signal read out is measured using a sensor comprising at least two read-out wells of different capacities, and if the output well of lower capacity is saturated during the measurement, then a shift Is made to using the read-out well of larger capacity.

24. Method according to any one of the preceding claims 17-23, **characterized in that** dynamics is changed by changing binning of charges at least partly in response to a control signal and/or according to a control signal.

25. Method according to claim 24, **characterized in that** the binning of charges is changed during imaging.

26. Method according to any one of the preceding claims 17-25, **characterized in that** the signal level of the signal read out from the CCD sensor (1-1) is measured, and if the signal level exceeds a predefined threshold value, then the read-out of charges from the sensor is adjusted in such manner that, before the charges in the read-out well are read out, the number of pixels to be transferred into the read-out well is decreased, and if the signal level is below the predefined threshold value, then the read-out of information is adjusted In such manner that, before the charges in the read-out well are read out, the number of pixels to be transferred into the read-out well is increased.

27. Method according to claim 26, **characterized in that** the predefined threshold value is determined as a function of saturation level of the read-out well.

28. Method according to any one of the preceding claims 17-27, **characterized in that**, if either one of the read-out wells is saturated, then external binning of charges outside the sensor is increased.

29. Method according to any one of claims 18-28, **characterized in that**, if the A/D conversion exceeds (3-4) the predefined first threshold value and the read-out well (1-6, 1-8) of larger capacity is being used, then a check (3-18) is made to determine whether the register-direction maximum external binning outside the sensor has already been reached, and if not, then a shift (3-20) is made to using a larger register-direction external binning outside the sensor to read the next vertical line.

30. Method according to any one of the preceding claims 18-29, **characterized in that** a shift (3-22) is made to using the read-out well (1-6, 1-8) of smaller capacity if the A/D conversion is below a second predefined threshold value.

31. Method according to any one of the preceding claims 18-30, **characterized in that**, if the A/D conversion does not exceed the predefined first threshold value, then a check (3-6) is made to determine whether the A/D conversion value is below the second predefined threshold value, and if the A/D conversion value is below the second predefined threshold value, then an additional check (3-8) is made to determine whether the minimum register-direction external binning has been reached, and if not, then a shift (3-10) is made to using a smaller external binning to read the next vertical line.

32. Method according to any one of the preceding claims 17-31, **characterized in that**, if the minimum register-direction external binning has been reached, then a shift (3-12) Is made to using the read-out well (1-6, 1-8) of smaller capacity to read the next vertical line.

## Patentansprüche

1. CCD-Bildsensoranordnung (1-1) mit einem CCD-Sensor, mit:
- einem Detektor (1-2), der einen aktiven Bereich mit Bildelementen umfasst, die Ladungen aufnehmen;
- einem Ausleseregister (1-4), das funktional mit dem vorgenannten aktiven Bereich in Zusammenhang steht;
- einer Einrichtung zum Übertragen von Ladungen von dem aktiven Bereich in das Ausleseregister (1-4);
- einer Einrichtung zum Übertragen von Ladungen an einen Ausgang (1-4a, 1-4b) des Ausleseregisters (1-4);
- zumindest zwei Auslesepools, nämlich einem ersten und einem zweiten Auslesepool (1-6, 1-8), die funktional mit dem Ausleseregister (1-4) verbunden sind, wobei die zumindest zwei Auslesepools (1-6, 1-8) unterschiedliche Kapazitäten aufweisen; und
- einer Einrichtung zum Übertragen von Ladungen von dem Ausgang (1-4a, 1-4b) des Ausleseregisters (1-4) in einen Auslesepool(1-6, 1-8),
**dadurch gekennzeichnet, dass** in dem Sensor oder der funktionaler Verbindung mit dem Sensor eingerichtet sind: eine Einrichtung zum Messen des Signals, das durch die Ladungen während einer Auslesung eines Bilds aus dem Sensor erzeugt wird, ebenso wie eine Auswahleinrichtung zum Entscheiden, während der Auslesung des Bilds aus dem Sensor, ob der Auslesepool (1-6, 1-8), in den Ladungen von dem Ausleseregister (1-4) zu übertragen sind, zu ändern ist, auf Grundlage von dem vorgenannten gemessenen Signal.

2. Sensoranordnung gemäß Anspruch 1, **dadurch gekennzeichnet, dass** diese eine Einrichtung zum Durchführen einer A/D-Wandlung auf dem Signal aufweist und die Auswahleinrichtung angepasst ist, den Auslesepool (1-6, 1-8), durch den das von dem CCD-Sensor (1-1) kommende Signal zu lesen ist, nach der A/D-Wandlung auszuwählen.

3. Sensoranordnung gemäß Anspruch 1 oder 2, **dadurch gekennzeichnet, dass** in dem Sensor oder in funktionaler Verbindung mit dem Sensor eine Einrichtung eingerichtet ist, die angepasst ist, zu prüfen (3-4), ob zumindest ein Teil des gemessenen Signals einen vordefinierten ersten Schwellenwert überschreitet oder unter diesem liegt, und, falls dies der Fall ist, ein Signal zu geben, dass der zu verwendende Auslesepool (1-6, 1-8) auf einen anderer Kapazität zu ändern ist.

4. Sensoranordnung gemäß einem der vorhergehenden Ansprüche, **dadurch gekennzeichnet, dass** der Sensor zwei Auslesepools (1-6, 1-8) aufweist, die an entgegengesetzten Enden des Ausleseregisters (1-4) oder an einem Ende des Ausleseregisters liegen.

5. Sensoranordnung gemäß einem der vorhergehenden Ansprüche, **dadurch gekennzeichnet, dass** der Sensor einen ersten und einen zweiten Auslesepool (1-6, 1-8) aufweist und die Kapazität des zweiten Auslesepools (1-6) gleich ungefähr dem Doppelten der Kapazität des ersten Auslesepools (1-8) ist.

6. Sensoranordnung gemäß einem der vorhergehenden Ansprüche, **dadurch gekennzeichnet, dass** diese ein Register zum Summieren der Ladungen vor einer Übertragung von diesen in das Ausleseregister (1-4) aufweist, das zwischen dem Detektor (1-2) und dem Ausleseregister (1-4) in funktionaler Verbindung mit diesen eingerichtet ist.

7. Sensoranordnung gemäß einem der vorhergehenden Ansprüche, **dadurch gekennzeichnet, dass** diese ein Register aufweist, wohin die Ladungen der Bildelemente des aktiven Bereichs vor einer Übertragung von diesen in das Ausleseregister (1-4) übertragen werden können.

8. Sensoranordnung gemäß einem der vorhergehenden Ansprüche, **dadurch gekennzeichnet, dass** die Anordnung eine Einrichtung zum Ändern der Dynamik durch Änderung einer Zusammenfassung von Ladungen zumindest teilweise in Erwiderung auf ein Steuersignal aufweist.

9. Sensoranordnung gemäß einem der vorhergehenden Ansprüche, **dadurch gekennzeichnet, dass** die Anordnung eine Einrichtung zum Änderung der Dynamik durch Änderung einer Zusammenfassung von Ladungen zumindest teilweise gemäß einem Steuersignal während einer Übertragung von Ladungen von dem Ausgang (1-4a, 1-4b) des Ausleseregisters (1-4) in den zumindest einen Auslesepool (1-6, 1-8) zumindest teilweise in Erwiderung auf eine Steuersignal aufweist, wobei in dem Sensor oder in funktionaler Verbindung mit dem Sensor eingerichtet sind: eine Einrichtung zum Messen des Signals, das durch die aus dem Auslesepool ausgelesenen Ladungen erzeugt wird, ebenso wie eine Auswahleinrichtung zum Entscheiden, ob die Zusammenfassung (1-6, 1-8) zu ändern ist, zumindest teilweise auf Grundlage des gemessenen Signals.

10. Sensoranordnung gemäß Anspruch 8 oder 9, **dadurch gekennzeichnet, dass** diese eine Einrichtung zum Ändern der Zusammenfassung auf Übertragung von Ladungen von dem aktiven Bereich des Detektors an das Ausleseregister hin und/oder auf Übertragung von Ladungen von dem Ausleseregister an den Auslesepool hin aufweist.

11. Sensoranordnung gemäß einem der vorhergehenden Ansprüche 8 bis 10, **dadurch gekennzeichnet, dass** das Steuersignal auf einem von dem CCD-Sensor ausgelesenen Signal basiert.

12. Sensoranordnung gemäß einem der vorhergehenden Ansprüche 8 bis 11, **dadurch gekennzeichnet, dass** die Anordnung eine Einrichtung zum Normieren des Bildsignals aufweist, wobei die Normierungseinrichtung ein digitales Summieren der Signale umfasst, die durch Bildelemente produziert werden, die physikalisch benachbart zueinander auf dem Sensor liegen.

13. Sensoranordnung gemäß Anspruch 12, **dadurch gekennzeichnet, dass** die Normierungseinrichtung eine Einrichtung zur Korrektur des Dunkelstroms und/oder der Verstärkung und/oder des Elektronikversatzes aufweist, die von der Zusammenfassung abhängig sind.

14. Sensoranordnung gemäß Anspruch 12 oder 13, **dadurch gekennzeichnet, dass** die Summierung und/oder die Korrektur teilweise elektronisch und teilweise mittels Software implementiert ist/sind.

15. Sensoranordnung gemäß einem der vorhergehenden Ansprüche, **dadurch gekennzeichnet, dass** diese eine Einrichtung aufweist, die angepasst ist, die zu verwendende Zusammenfassung und/oder der zu verwendende Auslesepool auf Grundlage von zumindest einem Taktpuls zu bestimmen, und/oder eine Einrichtung zum Ändern des Taktpulses zumindest teilweise auf Grundlage des von dem CCD-Sensor kommenden Signals aufweist.

16. Sensoranordnung gemäß einem der vorhergehenden Ansprüche 2 bis 15, **dadurch gekennzeichnet, dass** diese eine Einrichtung aufweist, die angepasst ist, zu prüfen (3-4), ob die A/D-Wandlung einen vordefinierten ersten Schwellenwert überschreitet, und, falls die A/D-Wandlung den vordefnierten ersten Schwellenwert überschreitet, zusätzlich zu prüfen (3-14), ob der Auslesepool (1-6, 1-8) größerer Kapazität in Verwendung ist, und, falls dieser nicht in Verwendung ist, eine Umschaltung (3-6) zur Verwendung des Auslesepools (1-6, 1-8) größerer Kapazität anstelle des Auslesepools (1-6, 1-8) kleinerer Kapazität beim Lesen der nächsten vertikalen Reihe des Detektors vorzunehmen.

17. Verfahren zum Vergrößern der Dynamik eines CCD-Sensors (1-1), **dadurch gekennzeichnet, dass** zumindest zwei Auslesepools, nämlich ein erster und ein zweiter Auslesepool (1-6, 1-8) mit unterschiedlichen Kapazitäten in funktionaler Verbindung mit einem Ausleseregister (1-4) des CCD-Sensors (1-1) eingerichtet sind, wobei das Verfahren die Schritte aufweist:
- Aufnehmen von Ladungen in einem aktiven Bereich mit Bildelementen in zumindest einer vertikalen Reihe;
- Lesen (3-2) der Ladungen der ersten vertikalen Reihe von Bildelementen aus dem aktiven Bereich in das Ausleseregister (1-4);
- Übertragen der Ladungen an einen Ausgang (1-4a, 1-4b) des Ausleseregisters (1-4);
- Übertragen der Ladungen von dem Ausgang (1-4a, 1-4b) des Ausleseregisters (1-4) in einen Auslesepool (1-6, 1-8);
- Messen des Signals, das durch die über den Auslesepool (1-6, 1-8) aus dem Sensor kommenden Ladungen erzeugt wird; und
- Entscheiden, während einer Auslesung eines Bilds aus dem Sensor, ob der zu verwendende Auslesepool (1-6, 1-8) zu ändern ist, auf Grundlage von dem gemessenen Signal.

18. Verfahren gemäß Anspruch 17, **dadurch gekennzeichnet, dass** eine A/D-Wandlung auf dem Signal von zumindest einem Auslesepool durchgeführt wird und der Auslesepool (1-6, 1-8), durch den das von dem CCD-Sensor (1-1) kommende Signal zu lesen ist, nach der A/D-Wandlung ausgewählt wird.

19. Verfahren gemäß Anspruch 17 oder 18, **dadurch gekennzeichnet, dass** eine Bildelementreihe oder eine Anzahl von Bildelementen ausgelesen wird und eine Prüfung (3-4), ob das Signal einen vordefinierten Schwellenwert überschreitet oder unter diesem liegt, basierend auf einem Signal von zumindest einem Teil der ausgelesenen Bildelemente vorgenommen wird, und, falls dies der Fall ist, eine Umschaltung (3-16) zur Verwendung eines Auslesepools (1-6, 1-8) anderer Kapazität beim Lesen der nächsten vertikalen Reihe von Bildelementen vorgenommen wird.

20. Verfahren gemäß Anspruch 19, **dadurch gekennzeichnet, dass** vordefinierte Schwellenwerte 75% und 25% verwendet werden.

21. Verfahren gemäß einen der vorhergehenden Ansprüche 17 bis 20, **dadurch gekennzeichnet, dass** der Signalpegel des aus dem Sensor ausgelesenen Signals gemessen wird, und, falls der Signalpegel einen vordefinierten Schwellenwert überschreitet, die Auslesung von Ladungen aus dem Sensor derart angepasst wird, dass, bevor die Ladungen in dem Auslesepool ausgelesen werden, die Anzahl von Bildelementen, die in den Auslesepool zu übertragen sind, verringert wird, und, falls der Signalpegel unter dem vordefinierten Schwellenwert liegt, die Auslesung von Informationen derart angepasst wird, dass, bevor die Ladungen in dem Auslesepool ausgelesen werden, die Anzahl von Bildelementen, die in den Auslesepool zu übertragen sind, erhöht wird.

22. Verfahren gemäß Anspruch 21, **dadurch gekennzeichnet, dass** eine Entscheidung, ob der zu verwendende Auslesepool (1-6, 1-8) zu ändern ist, basierend auf einem vordefinierten Schwellenwert vorgenommen wird, der als eine Funktion eines Sättigungspegels des Auslesepools bestimmt wird.

23. Verfahren gemäß einem der vorhergehenden Ansprüche 17 bis 22, **dadurch gekennzeichnet, dass** der Signalpegel des ausgelesenen Signals unter Verwendung eines Sensors gemessen wird, der zumindest zwei Auslesepools unterschiedlicher Kapazitäten aufweist, und, falls der Auslesepool kleinerer Kapazität während der Messung gesättigt ist, eine Umschaltung zur Verwendung des Auslesepools größerer Kapazität vorgenommen wird.

24. Verfahren gemäß einem der vorhergehenden Ansprüche 17 bis 23, **dadurch gekennzeichnet, dass** eine Dynamik durch Änderung einer Zusammenfassung von Ladungen zumindest teilweise in Erwiderung auf ein Steuersignal und/oder gemäß einem Steuersignal geändert werden.

25. Verfahren gemäß Anspruch 24, **dadurch gekennzeichnet, dass** die Zusammenfassung von Ladungen während eines Bildgebungsvorgangs geändert wird.

26. Verfahren gemäß einem dem vorhergehenden Ansprüche 17 bis 25, **dadurch gekennzeichnet, dass** der Signalpegel des aus dem CCD-Sensor (1-1) ausgelesenen Signals gemessen wird, und, falls der Signalpegel einen vordefinierten Schwellenwert überschreitet, die Auslesung von Ladungen aus dem Sensor derart angepasst wird, dass, bevor die Ladungen in dem Auslesepool ausgelesen werden, die Anzahl von Bildelementen, die in den Auslesepool zu übertragen sind, verringert wird, und, falls der Signalpegel unter dem vordefinierten Schwellenwert liegt, die Auslesung von Informationen derart angepasst wird, dass, bevor die Ladungen in dem Auslesepool ausgelesen werden, die Anzahl von Bildelementen, die in den Auslesepool zu übertragen sind, erhöht wird.

27. Verfahren gemäß Anspruch 26, **dadurch gekennzeichnet, dass** der vorbestimmte Schwellenwert als eine Funktion eines Sättigungspegels des Auslesepools bestimmt wird.

28. Verfahren gemäß einem der vorhergehenden Ansprüche 17 bis 27, **dadurch gekennzeichnet, dass**, falls einer der Auslesepools gesättigt ist, eine externe Zusammenfassung von Ladungen außerhalb des Sensors vergrößert wird.

29. Verfahren gemäß einem der vorhergehenden Ansprüche 18 bis 28, **dadurch gekennzeichnet, dass**, falls die A/D-Wandlung den vordefinierten ersten Schwellenwert überschreitet (3-4) und der Auslesepool (1-6, 1-8) größerer Kapazität in Verwendung ist, eine Prüfung (3-18) vorgenommen wird, um zu bestimmen, ob die maximale externe Zusammenfassung außerhalb des Sensors in Registerrichtung bereits erreicht wurde, und, falls nicht, eine Umschaltung (3-20) zur Verwendung einer größeren externen Zusammenfassung außerhalb des Sensors In Registerrichtung zum Lesen der nächsten vertikalen Reihe vorgenommen wird.

30. Verfahren gemäß einem der vorhergehenden Ansprüche 18 bis 29, **dadurch gekennzeichnet, dass** eine Umschaltung (3-22) zur Verwendung des Auslesepools (1-6, 1-8) kleinerer Kapazität vorgenommen wird, falls die A/D-Wandlung unter einem zweiten vordefinierten Schwellenwert liegt.

31. Verfahren gemäß einem der vorhergehenden Ansprüche 18 bis 30, **dadurch gekennzeichnet, dass**, falls die A/D-Wandlung nicht den vordefinierten ersten Schwellenwert überschreitet, eine Prüfung (3-6) vorgenommen wird, um zu bestimmen, ob der A/D-Wandlungswert unter dem zweiten vordefinierten Schwellenwert liegt, und, falls der A/D-Wandlungswert unter dem zweiten vordefinierten Schwellenwert liegt, eine zusätzliche Prüfung (3-8) vorgenommen wird, um zu bestimmen, ob die minimale externe Zusammenfassung in Registerrichtung erreicht wurde, und, falls nicht, eine Umschaltung (3-10) zur Verwendung einer kleineren externen Zusammenfassung zum Lesen der nächsten vertikalen Reihe vorgenommen wird.

32. Verfahren gemäß einem der vorhergehenden Ansprüche 17 bis 31, **dadurch gekennzeichnet, dass**, falls die minimale externe Zusammenfassung in Registerrichtung erreicht wurde, eine Umschaltung (3-12) zur Verwendung des Auslesepools (1-6, 1-8) kleinerer Kapazität zum Lesen der nächsten vertikalen Reihe vorgenommen wird.

## Revendications

1. Agencement de capteur d'image CCD (1-1), comprenant un capteur CCD, qui comprend :
- un détecteur (1-2) qui comprend une zone active comprenant des pixels qui reçoivent des charges ;
- un registre de lecture (1-4) qui est associé fonctionnellement à la zone active susmentionnée ;
- des moyens pour transférer des charges de la zone active dans le registre de lecture (1-4) ;
- des moyens pour transférer des charges à une sortie (1-4a, 1-4b) du registre de lecture (1-4) ;
- au moins deux, un premier et un deuxième, puits de lecture (1-6, 1-8) connectés fonctionnellement au registre de lecture (1-4), lesdits au moins deux puits de lecture (1-6, 1-8) ayant différentes capacités ; et
- des moyens pour transférer des charges de la sortie (1-4a, 1-4b) du registre de lecture (1-4) dans un puits de lecture (1-6, 1-8),
**caractérisé en ce que** des moyens sont agencés dans le capteur ou dans une connexion fonctionnelle avec le capteur pour mesurer le signal généré par les charges pendant une lecture d'une image à partir du capteur, ainsi que des moyens de sélection pour décider, pendant ladite lecture de ladite image à partir du capteur, sur la base du signal mesuré susmentionné, si le puits de lecture (1-6, 1-8) dans lequel des charges doivent être transférées par ledit registre de lecture (1-4) doit être changé.

2. Agencement de capteur selon la revendication 1, **caractérisé en ce qu'**il comprend un moyen pour appliquer une conversion analogique-numérique au dit signal et ledit moyen de sélection est conçu pour sélectionner, après la conversion analogique-numérique, le puits de lecture (1-6, 1-8) par lequel le signal provenant du capteur CCD (1-1) doit être lu.

3. Agencement de capteur selon la revendication 1 ou 2, **caractérisé en ce que** des moyens sont agencés dans le capteur ou en connexion fonctionnelle avec le capteur, qui sont conçus pour contrôler (3-4) si au moins une partie du signal mesuré est supérieure ou est inférieure à une première valeur de seuil prédéfinie ; et, si c'est le cas, pour communiquer un signal indiquant que le puits de lecture (1-6, 1-8) à utiliser doit être changé en un puits d'une capacité différente.

4. Agencement de capteur selon l'une quelconque des revendications précédentes, **caractérisé en ce que** le capteur comprend deux puits de lecture (1-6, 1-8) qui sont situés aux extrémités opposées du registre de lecture (1-4) ou à une extrémité du registre de lecture.

5. Agencement de capteur selon l'une quelconque des revendications précédentes, **caractérisé en ce que** le capteur comprend des premier et deuxième puits de lecture (1-6, 1-8) et la capacité du deuxième puits de lecture (1-6) est égale à environ deux fois la capacité du premier puits de lecture (1-8).

6. Agencement de capteur selon l'une quelconque des revendications précédentes, **caractérisé en ce qu'**il comprend un registre agencé entre le détecteur (1-2) et le registre de lecture (1-4), en connexion fonctionnelle avec ceux-ci, pour sommer les charges avant le transfert de celles-ci dans le registre de lecture (1-4).

7. Agencement de capteur selon l'une quelconque des revendications précédentes, **caractérisé en ce qu'**il comprend un registre dans lequel les charges des pixels de la zone active peuvent être transférées avant le transfert de celles-ci dans le registre de lecture (1-4).

8. Agencement de capteur selon l'une quelconque des revendications précédentes, **caractérisé en ce que** l'agencement comprend des moyens pour changer les dynamiques en changeant un regroupement de charges au moins partiellement en réponse à un signal de commande.

9. Agencement de capteur selon l'une quelconque des revendications précédentes, **caractérisé en ce que** l'agencement comprend des moyens pour changer les dynamiques en changeant un regroupement des charges au moins partiellement en fonction d'un signal de commande pendant le transfert de charges de la sortie (1-4a, 1-4b) du registre de lecture (1-4) dans ledit au moins un puits de lecture (1-6, 1-8) au moins partiellement en réponse à un signal de commande, moyennant quoi un moyen est agencé dans le capteur ou en connexion fonctionnelle avec le capteur pour mesurer le signal généré par les charges extraites du puits de lecture ainsi que des moyens de sélection pour décider, au moins partiellement sur la base du signal mesuré, si le regroupement (1-6, 1-8) doit être changé.

10. Agencement de capteur selon la revendication 8 ou 9, **caractérisé en ce qu'**il comprend des moyens pour changer le regroupement lors du transfert de charges de ladite zone active du détecteur dans le registre de lecture et/ou lors du transfert de charges du registre de lecture dans le puits de lecture.

11. Agencement de capteur selon l'une quelconque des revendications 8 à 10 précédentes, **caractérisé en ce que** le signal de commande est basé sur un signal extrait du capteur CCD.

12. Agencement de capteur selon l'une quelconque des revendications 8 à 11 précédentes, **caractérisé en ce que** l'agencement comprend des moyens pour normaliser le signal d'image, lesquels moyens de normalisation comprennent une sommation numérique des signaux produits par des pixels situés physiquement de manière adjacents les uns aux autres sur le capteur.

13. Agencement de capteur selon la revendication 12, **caractérisé en ce que** les moyens de normalisation comprennent des moyens pour corriger le courant d'obscurité et/ou le gain et/ou le décalage électronique en fonction du regroupement.

14. Agencement de capteur selon la revendication 12 ou 13, **caractérisé en ce que** la sommation et/ou la correction est mise/sont mises en oeuvre partiellement électroniquement et partiellement par logiciel.

15. Agencement de capteur selon l'une quelconque des revendications précédentes, **caractérisé en ce qu'**il comprend des moyens conçus pour déterminer le regroupement à utiliser et/ou le puits de sortie à utiliser sur la base au moins d'une impulsion d'horloge et/ou des moyens pour changer l'impulsion d'horloge au moins partiellement sur la base du signal provenant du capteur CCD.

16. Agencement de capteur selon l'une quelconque des revendications 2 à 15 précédentes, **caractérisé en ce qu'**il comprend des moyens conçus pour contrôler (3-4) si la conversion analogique-numérique est supérieure à une première valeur de seuil prédéfinie ; et, si la conversion analogique-numérique est supérieure à la première valeur de seuil prédéfinie, pour contrôler en outre (3-14) si le puits de lecture (1-6, 1-8) de plus grande capacité est utilisé, et s'il n'est pas utilisé, pour passer (3-6) à l'utilisation, lors de la lecture de la ligne verticale suivante du détecteur, au puits de lecture (1-6, 1-8) de plus grande capacité au lieu du puits de lecture (1-6, 1-8) de plus petite capacité.

17. Procédé pour étendre les dynamiques d'un capteur CCD (1-1), **caractérisé en ce qu'**au moins deux, un premier et un deuxième, puits de lecture (1-6, 1-8) ayant différentes capacités sont agencés en connexion fonctionnelle avec un registre de lecture (1-4) du capteur CCD (1-1), lequel procédé comprend les étapes :
- de réception de charges dans une zone active comprenant des pixels dans au moins une ligne verticale ;
- de lecture (3-2) des charges de la première ligne verticale de pixels de la zone active dans le registre de lecture (1-4) ;
- de transfert des charges vers une sortie (1-4a, 1-4b) du registre de lecture (1-4) ;
- de transfert des charges de la sortie (1-4a, 1-4b) du registre de lecture (1-4) dans un puits de lecture (1-6, 1-8) ;
- de mesure du signal généré par les charges sortant du capteur par l'intermédiaire dudit puits de lecture (1-6, 1-8) ; et
- de décision, pendant la lecture d'une image à partir du capteur et sur la base du signal mesuré, si le puits de lecture (1-6, 1-8) à utiliser doit être changé.

18. Procédé selon la revendication 17, **caractérisé en ce qu'**une conversion analogique-numérique est appliquée au signal d'au moins un puits de lecture et, après la conversion analogique-numérique, le puits de lecture (1-6, 1-8) par lequel le signal provenant du capteur CCD (1-1) doit être lu est sélectionné.

19. Procédé selon la revendication 17 ou 18, **caractérisé en ce qu'**une ligne de pixels ou un certain nombre de pixels sont extraits et il est contrôlé (3-4), sur la base d'un signal d'au moins une partie desdits pixels extraits, si le signal est supérieur ou est inférieur à une valeur de seuil prédéfinie ; et si c'est le cas, un passage (3-16) à l'utilisation, lors de la lecture de la ligne verticale suivante de pixels, d'un puits de lecture (1-6, 1-8) d'une capacité différente est effectué.

20. Procédé selon la revendication 19, **caractérisé en ce que** des valeurs de seuil prédéfinies de 75 % et de 25 % sont utilisées.

21. Procédé selon l'une quelconque des revendications 17 à 20 précédentes, **caractérisé en ce que** le niveau de signal du signal extrait du capteur est mesuré, et si le niveau de signal est supérieur à une valeur de seuil prédéfinie, alors la lecture de charges à partir du capteur est ajustée d'une manière telle que, avant que les charges dans le puits de lecture soient extraites, le nombre de pixels à transférer dans le puits de lecture soit diminué, et si le niveau de signal est inférieur à la valeur de seuil prédéfinie, alors la lecture d'informations est ajustée d'une manière telle que, avant que les charges dans le puits de lecture soient extraites, le nombre de pixels à transférer dans le puits de lecture soit augmenté.

22. Procédé selon la revendication 21, **caractérisé en ce qu'**une décision si le puits de lecture (1-6, 1-8) à utiliser doit être changé est prise sur la base d'une valeur de seuil prédéfinie qui est déterminée en fonction du niveau de saturation du puits de lecture.

23. Procédé selon l'une quelconque des revendications 17 à 22 précédentes, **caractérisé en ce que** le niveau de signal du signal extrait est mesuré en utilisant un capteur comprenant au moins deux puits de lecture de différentes capacités, et si le puits de sortie de plus faible capacité est saturé pendant la mesure, alors un passage à l'utilisation du puits de lecture de plus grande capacité est effectué.

24. Procédé selon l'une quelconque des revendications 17 à 23 précédentes, **caractérisé en ce que** les dynamiques sont changées en changeant le regroupement de charges au moins partiellement en réponse à un signal de commande et/ou en fonction d'un signal de commande.

25. Procédé selon la revendication 24, **caractérisé en ce que** le regroupement de charges est changé pendant l'imagerie.

26. Procédé selon l'une quelconque des revendications 17 à 25 précédentes, **caractérisé en ce que** le niveau de signal du signal extrait du capteur CCD (1-1) est mesuré, et si le niveau de signal est supérieur à une valeur de seuil prédéfinie, alors la lecture de charges à partir du capteur est ajustée d'une manière telle que, avant que les charges dans le puits de lecture soient extraites, le nombre de pixels à transférer dans le puits de lecture soit diminué, et si le niveau de signal est inférieur à la valeur de seuil prédéfinie, alors la lecture d'informations est ajustée d'une manière telle que, avant que les charges dans le puits de lecture soient extraites, le nombre de pixels à transférer dans le puits de lecture soit augmenté.

27. Procédé selon la revendication 26, **caractérisé en ce que** la valeur de seuil prédéfinie est déterminée en fonction du niveau de saturation du puits de lecture.

28. Procédé selon l'une quelconque des revendications 17 à 27 précédentes, **caractérisé en ce que**, si l'un ou l'autre des puits de lecture est saturé, alors un regroupement externe de charges à l'extérieur du capteur est augmenté.

29. Procédé selon l'une quelconque des revendications 18 à 28, **caractérisé en ce que**, si la conversion analogique-numérique est supérieure (3-4) à la première valeur de seuil prédéfinie et si le puits de lecture (1-6, 1-8) de plus grande capacité est utilisé, alors un contrôle (3-18) est effectué pour déterminer si le regroupement externe maximum dans la direction de registre à l'extérieur du capteur a déjà été atteint, et si ce n'est pas le cas, alors un passage (3-20) à l'utilisation d'un regroupement externe plus grand dans la direction de registre à l'extérieur du capteur est effectué pour lire la ligne verticale suivante.

30. Procédé selon l'une quelconque des revendications 18 à 29 précédentes, **caractérisé en ce qu'**un passage (3-22) à l'utilisation du puits de lecture (1-6, 1-8) de plus petite capacité est effectué si la conversion analogique-numérique est inférieure à une deuxième valeur de seuil prédéfinie.

31. Procédé selon l'une quelconque des revendications 18 à 30 précédentes, **caractérisé en ce que**, si la conversion analogique-numérique n'est pas supérieure à la première valeur de seuil prédéfinie, alors un contrôle (3-6) est effectué pour déterminer si la valeur de conversion analogique-numérique est inférieure à la deuxième valeur de seuil prédéfinie, et si la valeur de conversion analogique-numérique est inférieure à la deuxième valeur de seuil prédéfinie, alors un contrôle supplémentaire (3-8) est effectué pour déterminer si le regroupement externe minimum dans la direction de registre a été atteint, et si ce n'est pas le cas, alors un passage (3-10) à l'utilisation d'un plus petit regroupement externe est effectué pour lire la ligne verticale suivante.

32. Procédé selon l'une quelconque des revendications 17 à 31 précédentes, **caractérisé en ce que**, si le regroupement externe minimum dans la direction de registre a été atteint, alors un passage (3-12) à l'utilisation du puits de lecture (1-6, 1-8) de plus faible capacité est effectué pour lire la ligne verticale suivante.
